(19) Europäisches Patentamt
European Patent Office
Office européen des brevets

(11) **EP 3 035 530 B1**

(12) **FASCICULE DE BREVET EUROPEEN**

(45) Date de publication et mention
de la délivrance du brevet:
**10.01.2018 Bulletin 2018/02**

(51) Int Cl.:
*H03K 3/2893* (2006.01)     *H02M 3/158* (2006.01)
*G01R 19/165* (2006.01)     *H02N 2/18* (2006.01)
*H03K 3/3565* (2006.01)     *H03K 17/30* (2006.01)
*H03K 3/021* (2006.01)

(21) Numéro de dépôt: **15199659.2**

(22) Date de dépôt: **11.12.2015**

(54) **CIRCUIT DE COMPARAISON D'UNE TENSION À UN SEUIL**

VERGLEICHSSCHALTKREIS EINER SPANNUNG MIT EINER SCHWELLE

CIRCUIT FOR COMPARING A VOLTAGE TO A THRESHOLD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.12.2014 FR 1462427**

(43) Date de publication de la demande:
**22.06.2016 Bulletin 2016/25**

(73) Titulaires:
• **COMMISSARIAT À L'ÉNERGIE ATOMIQUE ET
AUX
ÉNERGIES ALTERNATIVES
75015 Paris (FR)**
• **STmicroelectronics SA
92120 Montrouge (FR)**

(72) Inventeurs:
• **TROCHUT, Séverin
73200 GILLY SUR ISERE (FR)**
• **WILLEMIN, Jérôme
38210 TULLINS (FR)**
• **BOISSEAU, Sébastien
38130 Echirolles (FR)**
• **MONFRAY, Stéphane
38320 EYBENS (FR)**

(74) Mandataire: **Thibon, Laurent
Cabinet Beaumont
1, rue Champollion
38000 Grenoble (FR)**

(56) Documents cités:
EP-A2- 2 323 015     DE-A1- 3 044 658
GB-A- 1 134 230     US-A- 5 952 870
US-A1- 2013 066 594     US-B1- 6 259 292
US-B1- 7 105 982

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

# Description

Domaine

La présente demande concerne les circuits électroniques de façon générale, et vise plus particulièrement un circuit de comparaison d'une tension à un seuil. Elle vise en particulier un circuit à consommation réduite, pouvant notamment être utilisé dans un générateur à récupération d'énergie ambiante. Elle vise en outre un générateur à récupération d'énergie ambiante comportant un tel circuit.

Exposé de l'art antérieur

Pour alimenter des systèmes électroniques à faible consommation d'énergie, on a proposé d'utiliser des générateurs adaptés à convertir de l'énergie disponible dans l'environnement du système, par exemple de l'énergie mécanique ou de l'énergie thermique, en énergie électrique.

Un tel générateur comprend typiquement un élément de conversion de l'énergie ambiante en électricité, par exemple un élément piézoélectrique, et un circuit de conversion d'énergie électrique, placé en aval de l'élément de conversion d'énergie ambiante en électricité, adapté à transformer l'énergie électrique fournie par l'élément de conversion en énergie électrique exploitable par un système électronique.

Le circuit de conversion d'énergie électrique peut comprendre un circuit adapté à comparer une tension d'entrée à un seuil, et à fournir une alimentation électrique à une charge lorsque la tension d'entrée dépasse ce seuil.

On s'intéresse ici plus particulièrement à un circuit adapté à comparer une tension d'entrée à un seuil et à fournir une tension d'alimentation à une charge lorsque la tension d'entrée dépasse le seuil, ce circuit ne nécessitant pas d'alimentation autre que la tension d'entrée pour son fonctionnement. Un tel circuit est divulgué par exemple dans le document US 7,105,98.

Un objet d'un mode de réalisation est de prévoir un tel circuit selon les revendications 1 à 8, présentant une consommation électrique réduite par rapport aux circuits existants.

Un objet d'un mode de réalisation est de prévoir un générateur à récupération d'énergie ambiante selon les revendications 9 à 14, comportant un tel circuit.

Résumé

Ainsi, un mode de réalisation prévoit un circuit de comparaison d'une tension à un seuil, comportant : des premier et deuxième noeuds d'application de ladite tension ; une première branche comportant un premier transistor en série avec une première résistance entre les premier et deuxième noeuds ; une deuxième branche parallèle à la première branche, comportant des deuxième et troisième résistances en série formant un pont diviseur de tension entre les premier et deuxième noeuds, le point milieu du pont diviseur étant connecté à un noeud de commande du premier transistor ; et une troisième branche comportant un deuxième transistor en série avec un élément résistif et/ou capacitif, entre le noeud de commande du premier transistor et le premier ou deuxième noeud, un noeud de commande du deuxième transistor étant connecté au point milieu de l'association en série du premier transistor et de la première résistance.

Selon un mode de réalisation, le point milieu de l'association en série du deuxième transistor et de l'élément résistif et/ou capacitif, et le noeud d'application de ladite tension non connecté à la troisième branche, constituent des noeuds de fourniture d'une tension de sortie du circuit, destinés à être connectés à une charge à alimenter.

Selon un mode de réalisation, le circuit comporte en outre : entre le point milieu de l'association en série du deuxième transistor et de l'élément résistif et/ou capacitif, et le noeud d'application de ladite tension non connecté à la troisième branche, une quatrième résistance ; et entre le noeud d'application de ladite tension non connecté à la troisième branche et un troisième noeud, un troisième transistor dont un noeud de commande est relié au point milieu de l'association en série du deuxième transistor et de l'élément résistif et/ou capacitif, dans lequel le noeud d'application de ladite tension connecté à la troisième branche, et le troisième noeud, constituent des noeuds de fourniture d'une tension de sortie du circuit, destinés à être connectés à une charge à alimenter.

Selon un mode de réalisation : le premier transistor est un transistor bipolaire NPN ou un transistor MOS à canal N ; le deuxième transistor est un transistor MOS à canal P ou un transistor bipolaire PNP ; dans la première branche, la première résistance est côté premier noeud et le premier transistor est côté deuxième noeud ; et la troisième branche est entre le noeud de commande du premier transistor et le premier noeud.

Selon un mode de réalisation : le premier transistor est un transistor bipolaire PNP ou un transistor MOS à canal P ; le deuxième transistor est un transistor MOS à canal N ou un transistor bipolaire NPN ; dans la première branche, la première résistance est côté deuxième noeud et le premier transistor est côté premier noeud ; et la troisième branche est entre le noeud de commande du premier transistor et le deuxième noeud.

Selon un mode de réalisation, l'élément résistif et/ou capacitif est une résistance.

Selon un mode de réalisation, l'élément résistif et/ou capacitif est une cellule RC comportant une résistance et un condensateur.

Selon un mode de réalisation, au moins l'une des deuxième et troisième résistances est une thermistance ou une association d'une ou plusieurs résistances et d'une ou plusieurs thermistances.

Un autre mode de réalisation prévoit un générateur à récupération d'énergie ambiante, comportant : un élément de conversion d'énergie ambiante en énergie électrique ; un premier condensateur adapté à stocker des charges générées par ledit élément de conversion ; et un premier circuit de comparaison du type susmentionné, le premier condensateur étant connecté entre les premier et deuxième noeuds du premier circuit de comparaison.

Selon un mode de réalisation, le générateur comporte en outre un circuit de chargement inductif d'un deuxième condensateur à partir de la tension d'entrée et du premier circuit de comparaison.

Selon un mode de réalisation, le circuit de chargement inductif est un circuit abaisseur de tension.

Selon un mode de réalisation, le circuit de chargement inductif est un circuit élévateur de tension.

Selon un mode de réalisation, le générateur comporte en outre un deuxième circuit de comparaison du type susmentionné, le deuxième condensateur étant connecté entre les premier et deuxième noeuds du deuxième circuit de comparaison.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 est un schéma électrique illustrant un exemple d'un mode de réalisation d'un circuit de comparaison d'une tension à un seuil ;
la figure 2 est un schéma électrique illustrant une variante de réalisation d'un circuit de comparaison d'une tension à un seuil ;
la figure 3 est un schéma électrique illustrant une autre variante de réalisation d'un circuit de comparaison d'une tension à un seuil ;
la figure 4 est un schéma électrique illustrant une autre variante de réalisation d'un circuit de comparaison d'une tension à un seuil ;
la figure 5 est un schéma électrique illustrant un exemple d'un mode de réalisation d'un générateur à récupération d'énergie ambiante ;
la figure 6 est un schéma électrique d'une variante de réalisation d'un générateur à récupération d'énergie ambiante ;
la figure 7 est un schéma électrique d'une autre variante de réalisation d'un générateur à récupération d'énergie ambiante ; et
la figure 8 est un schéma électrique d'une autre variante de réalisation d'un générateur à récupération d'énergie ambiante.

Description détaillée

De mêmes éléments ont été désignés par de mêmes références aux différentes figures. De plus, dans la présente description, sauf indication contraire, les termes "approximativement", "sensiblement", "environ", "de l'ordre de", etc., signifient "à 20 % près", ou, lorsqu'il s'agit d'une tension nulle, "comprise entre -300 et 300 mV", ou, lorsqu'il s'agit d'un courant nul, "compris entre -50 et 50 nA". Par ailleurs, dans la présente description, on utilisera le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

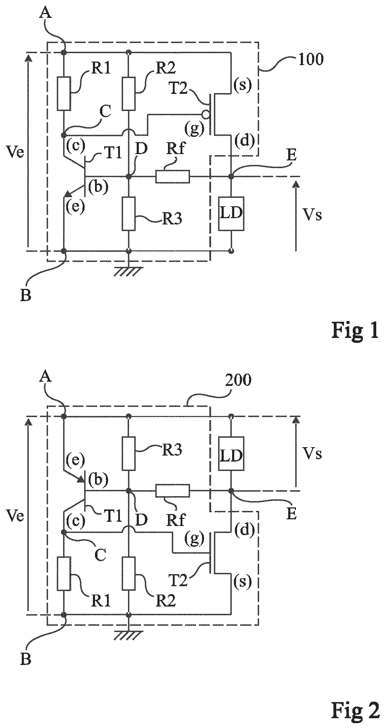

La figure 1 est un schéma électrique illustrant un exemple d'un mode de réalisation d'un circuit de comparaison d'une tension d'entrée Ve à un seuil.

Le circuit de comparaison 100 de la figure 1 comprend une première branche comportant une résistance R1 et un transistor T1 en série entre des noeuds A et B d'application de la tension Ve. Plus particulièrement, dans l'exemple représenté, la résistance R1 a une première extrémité reliée au noeud A et une deuxième extrémité reliée à un noeud C, et le transistor T1 a un premier noeud de conduction relié au noeud C et un deuxième noeud de conduction relié au noeud B. Dans l'exemple représenté, le transistor T1 est un transistor bipolaire de type NPN, dont le collecteur (c) est relié au noeud C et dont l'émetteur (e) est relié au noeud B.

Le circuit 100 comprend en outre une deuxième branche parallèle à la première branche, comportant deux résistances R2 et R3 en série entre les noeuds A et B. Plus particulièrement, dans l'exemple représenté, la résistance R2 a une première extrémité reliée au noeud A et une deuxième extrémité reliée à un noeud D, et la résistance R3 a une première extrémité reliée au noeud D et une deuxième extrémité reliée au noeud B. Les résistances R2 et R3 forment un pont diviseur de tension. Le noeud D, ou point milieu du pont diviseur, est relié à un noeud de commande du transistor T1, à savoir la base (b) du transistor T1 dans l'exemple représenté.

Le circuit 100 comprend en outre une troisième branche, comportant un transistor T2 en série avec un élément résistif Rf, entre le noeud A et le noeud D. Plus particulièrement, dans l'exemple représenté, la résistance Rf a une première extrémité reliée au noeud D et une deuxième extrémité reliée à un noeud E, et le transistor T2 a un premier noeud de conduction relié au noeud E et un deuxième noeud de conduction relié au noeud A. Dans l'exemple représenté, le transistor T2 est un transistor MOS à canal P dont la source (s) est reliée au noeud A et dont le drain (d) est relié au noeud E. Un noeud de commande du transistor T2, sa grille (g) dans cet exemple, est relié au noeud C.

La tension d'entrée Ve peut être une tension continue fournie par une source d'énergie électrique (non représentée), par exemple la tension aux bornes d'un condensateur de collecte de charges électriques générées par un élément de conversion d'énergie ambiante en électricité. Les noeuds E et B sont des noeuds de fourniture d'une tension de sortie Vs du circuit 100. Une charge LD à alimenter, par exemple un capteur sans fil (capteur de température, d'humidité, de luminosité, etc.), une source lumineuse utilisant par exemple une diode électroluminescente ou un ensemble de diodes électroluminescentes, etc., est connectée entre les noeuds E et B du circuit 100.

Le fonctionnement du circuit 100 est le suivant. Lorsque la tension d'entrée Ve est basse, la tension aux bornes de la résistance R3 du pont diviseur n'est pas suffisante pour mettre en conduction le transistor T1. Le transistor T1 est donc bloqué. La tension aux bornes de la résistance R1, correspondant à la tension grille-source du transistor T2 dans cet exemple, est alors sensiblement nulle. Le transistor T2 est donc bloqué. Le courant traversant la charge LD est alors sensiblement nul, et la charge LD n'est pas alimentée. La tension de sortie Vs du circuit 100 est alors approximativement nulle.

L'élément résistif Rf contribue alors à abaisser le potentiel du noeud D en le tirant vers celui du noeud E (alors sensiblement égal à celui du noeud B), et renforce donc le blocage du transistor T1.

Lorsque la tension Ve augmente jusqu'à franchir un seuil $V_{SH}$, la tension aux bornes de la résistance R3 atteint le seuil de mise en conduction du transistor T1. Le transistor T1 devient alors passant, et un courant circule dans la branche comportant la résistance R1 et le transistor T1. La tension aux bornes de la résistance R1, ou tension source-grille du transistor T2 dans cet exemple, augmente alors jusqu'à atteindre le seuil de mise en conduction du transistor T2. Le transistor T2 devient donc lui aussi passant. La charge LD est alors alimentée, et la tension de sortie Vs du circuit 100 devient sensiblement égale à la tension d'entrée Ve (à la chute de tension du transistor T2 près).

L'élément résistif Rf tend alors à rehausser le potentiel du noeud D en le tirant vers celui du noeud E (alors sensiblement égal à celui du noeud A), et contribue donc au maintien à l'état passant du transistor T1.

Lorsque la tension Ve redescend sous un seuil $V_{SB}$ inférieur au seuil $V_{SH}$, la tension aux bornes de la résistance R3 n'est plus suffisante pour maintenir le transistor T1 à l'état passant. Le transistor T1 se bloque donc, et la tension aux bornes de la résistance R1 devient sensiblement nulle, entrainant le blocage du transistor T2. Il en résulte que la charge LD n'est plus alimentée, et la tension Vs de sortie du circuit 100 devient sensiblement nulle.

La présence de la résistance Rf, ou résistance de rétroaction, entre les noeuds D et E, confère au circuit 100 un fonctionnement à hystérésis, c'est-à-dire que son seuil $V_{SH}$ de commutation de l'état bloqué ($Vs \approx 0$) vers l'état passant ($Vs \approx Ve$) est supérieur au seuil de commutation $V_{SB}$ de l'état passant vers l'état bloqué. Ceci permet d'éviter une oscillation indésirable entre le mode alimenté et le mode non alimenté de la charge LD, notamment dans le cas où la commutation de l'état bloqué vers l'état passant s'accompagne d'un fort appel de courant dans la charge LD.

En notant Von la tension de mise en conduction du transistor T1, c'est-à-dire la tension à appliquer aux bornes de la résistance R3 pour rendre le transistor T1 conducteur, les seuils $V_{SH}$ et $V_{SB}$ peuvent être calculés comme suit :

$$V_{SH} \approx Von * \frac{^1/_{R3} + ^1/_{R2} + ^1/_{Rf}}{^1/_{R2}} \; ;$$

et

$$V_{SB} \approx Von * \frac{^1/_{R3} + ^1/_{R2} + ^1/_{Rf}}{^1/_{R2} + ^1/_{Rf}} .$$

Les valeurs des résistances R1, R2, R3 et Rf sont de préférence relativement élevées pour limiter la consommation électrique du circuit 100. A titre d'exemple, la résistance R1, la résistance R2+R3 du pont diviseur, et la résistance Rf, sont supérieures à 5 MΩ, et de préférence supérieures à 50 MΩ. Par exemple, la résistance R1 est d'environ 10 MΩ, la résistance R2 est d'environ 50 MΩ, la résistance R3 est d'environ 7 MΩ, et la résistance Rf est d'environ 150 MΩ.

A titre de variante, le transistor T1 peut être remplacé par un transistor MOS à canal N dont la source, le drain et la grille sont respectivement reliés au noeud B, au noeud C et au noeud D. L'utilisation d'un transistor bipolaire présente toutefois l'avantage d'améliorer la précision des seuils de commutation, dans la mesure où la tension de mise en conduction d'un transistor bipolaire est généralement moins sensible aux variations de température et aux dispersions de fabrication que celle d'un transistor MOS.

Par ailleurs, le transistor T2 peut être remplacé par un transistor bipolaire de type PNP dont l'émetteur, le collecteur et la base sont respectivement reliés au noeud A, au noeud E et au noeud C. L'utilisation d'un transistor MOS présente toutefois l'avantage de limiter la consommation du circuit 100, un transistor bipolaire consommant en effet un courant de base à l'état passant.

La figure 2 est un schéma électrique illustrant une variante de réalisation d'un circuit de comparaison d'une tension d'entrée Ve à un seuil. Le circuit de comparaison 200 de la figure 2 comprend sensiblement les mêmes éléments que le circuit 100 de la figure 1, et diffère du circuit 100 de la figure 1 essentiellement en ce que les types de conductivité des transistors T1 et T2 sont inversés, en ce que les positions du transistor T1 et de la résistance R1 sont interverties, en ce que les positions des résistances R2 et R3 sont interverties, et en ce que les positions du transistor T2 et de la charge LD sont interverties. En d'autres termes, dans le circuit 200, les noeuds de conduction du transistor T1 sont reliés aux noeuds A et C, les extrémités de la résistance R1 sont reliées aux noeuds C et B, les extrémités de la résistance R2 sont reliées aux noeuds D et B, les extrémités de la résistance R3 sont reliées aux noeuds D et A, les noeuds de conduction du transistor T2 sont reliés aux noeuds E et B, les extrémités de la résistance Rf sont reliées aux noeuds D et E, le noeud de commande du transistor T1 est relié au noeud D, le noeud de commande du transistor T2 est relié au noeud C, et la charge LD est connectée entre les noeuds A et E, qui constituent les noeuds de fourniture de la tension de sortie Vs du circuit 200. Comme dans l'exemple de la figure 1, la tension d'entrée Ve est appliquée entre les noeuds A et B.

Dans l'exemple représenté, le transistor T1 est un transistor bipolaire de type PNP dont l'émetteur (e) est relié au noeud A, dont le collecteur (c) est relié au noeud C et dont la base (b) est reliée au noeud D, et le transistor T2 est un transistor MOS à canal N dont la source (s) est reliée au noeud B, dont le drain (d) est relié au noeud E, et dont la grille (g) est reliée au noeud C.

Le fonctionnement du circuit 200 de la figure 2 est le suivant. Lorsque la tension d'entrée Ve est basse, la tension aux bornes de la résistance R3 du pont diviseur n'est pas suffisante pour mettre en conduction le transistor T1. Le transistor T1 est donc bloqué. La tension aux bornes de la résistance R1, correspondant à la tension grille-source du transistor T2 dans cet exemple, est alors sensiblement nulle. Le transistor T2 est donc bloqué. Le courant traversant la charge LD est alors sensiblement nul, et la charge LD n'est pas alimentée. La tension de sortie Vs du circuit 200 est alors approximativement nulle.

L'élément résistif Rf contribue à réhausser le potentiel du noeud D en le tirant vers celui du noeud E (alors sensiblement égal à celui du noeud A), et renforce donc le blocage du transistor T1.

Lorsque la tension Ve augmente jusqu'à franchir un seuil $V_{SH}$, la tension aux bornes de la résistance R3 atteint le seuil de mise en conduction du transistor T1. Le transistor T1 devient alors passant, et un courant circule dans la branche comportant la résistance R1 et le transistor T1. La tension aux bornes de la résistance R1, ou tension grille-source du transistor T2 dans cet exemple, augmente alors jusqu'à atteindre le seuil de mise en conduction du transistor T2. Le transistor T2 devient donc lui aussi passant. La charge LD est alors alimentée et la tension de sortie Vs du circuit 200 devient alors sensiblement égale à la tension d'entrée Ve (à la chute de tension du transistor T2 près).

L'élément résistif Rf tend alors à abaisser le potentiel du noeud D en le tirant vers celui du noeud E (alors sensiblement égal à celui du noeud B), et contribue donc au maintien à l'état passant du transistor T1.

Lorsque la tension Ve redescend sous un seuil $V_{SB}$ inférieur au seuil $V_{SH}$, la tension aux bornes de la résistance R3 n'est plus suffisante pour maintenir le transistor T1 à l'état passant. Le transistor T1 se bloque, et la tension aux bornes de la résistance R1 devient sensiblement nulle, entrainant le blocage du transistor T2. Il en résulte que la charge LD n'est plus alimentée, et la tension Vs de sortie du circuit 200 devient sensiblement nulle.

Ainsi, le circuit 200 présente un fonctionnement identique ou similaire à celui du circuit 100 de la figure 1, et présente, comme le circuit 100, un fonctionnement à hystérésis, les seuils de commutation haut $V_{SH}$ et bas $V_{SB}$ du circuit pouvant être calculés par les formules mentionnées ci-dessus en relation avec l'exemple de la figure 1 (Von désignant, comme dans l'exemple de la figure 1, la tension à appliquer aux bornes de la résistance R3 pour rendre le transistor T1 conducteur).

A titre de variante, le transistor T1 du circuit 200 peut être remplacé par un transistor MOS à canal P dont la source, le drain et la grille sont respectivement reliés au noeud A, au noeud C et au noeud D. L'utilisation d'un transistor bipolaire présente toutefois, comme dans l'exemple de la figure 1, l'avantage d'améliorer la précision des seuils de commutation $V_{SH}$ et $V_{SB}$.

Par ailleurs, le transistor T2 du circuit 200 peut être remplacé par un transistor bipolaire de type NPN dont l'émetteur, le collecteur et la base sont respectivement connectés au noeud B, au noeud E et au noeud C. Toutefois, comme dans l'exemple de la figure 1, l'utilisation d'un transistor MOS présente l'avantage de réduire la consommation électrique du circuit 200.

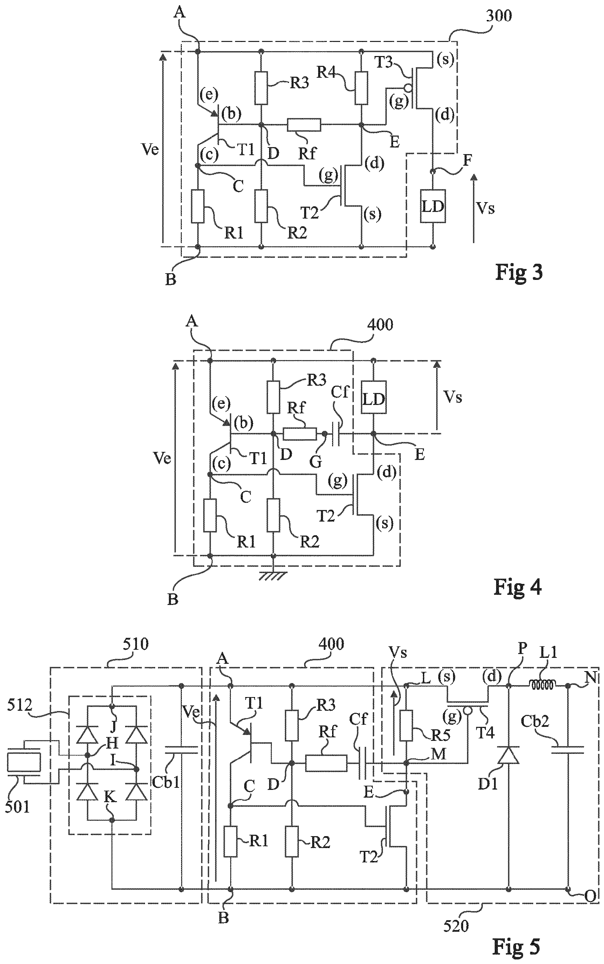

La figure 3 est un schéma électrique illustrant une autre variante de réalisation d'un circuit de comparaison d'une tension d'entrée Ve à un seuil. Le circuit de comparaison 300 de la figure 3 comprend les mêmes éléments que le circuit 200 de la figure 2, agencés sensiblement de la même manière que dans l'exemple de la figure 2, et diffère du circuit 200 de la figure 2 en ce qu'il comporte en outre une résistance R4 dont les extrémités sont reliées respectivement aux noeuds A et E, et un transistor T3 dont les noeuds de conduction sont reliés respectivement au noeud A et à un noeud F, et dont un noeud de commande est relié au noeud E.

La résistance R4 a de préférence une valeur inférieure à la résistance Rf, par exemple comprise entre 5% et 20% de la valeur de la résistance Rf, par exemple de l'ordre de 10% de la valeur de la résistance Rf, de façon à permettre le blocage du transistor T3 lorsque le transistor T2 est non passant.

Dans l'exemple représenté, le transistor T3 est un transistor MOS à canal P dont la source est reliée au noeud A, dont le drain est relié au noeud F, et dont la grille est reliée au noeud E.

Comme dans les exemples des figures 1 et 2, la tension d'entrée Ve est appliquée entre les noeuds A et B. Toutefois, dans l'exemple de la figure 3, la charge LD est connectée entre les noeuds F et B, qui constituent les noeuds de fourniture de la tension de sortie Vs du circuit.

Le fonctionnement du circuit 300 est le suivant. Lorsque la tension d'entrée Ve est basse, la tension aux bornes de la résistance R3 du pont diviseur n'est pas suffisante pour mettre en conduction le transistor T1, qui est donc bloqué. La tension aux bornes de la résistance R1 est alors sensiblement nulle, d'où il résulte que le transistor T2 est bloqué. La tension aux bornes de la résistance R4 est alors inférieure au seuil de commutation du transistor T3, et le transistor T3 est bloqué. La charge LD n'est alors pas alimentée, et la tension de sortie Vs du circuit 300 est approximativement nulle.

L'élément résistif Rf contribue à rehausser le potentiel du noeud D en le tirant vers celui du noeud E (alors sensiblement égal à celui du noeud A), et renforce donc le blocage du transistor T1.

Lorsque la tension Ve augmente jusqu'à franchir un seuil $V_{SH}$, la tension aux bornes de la résistance R3 atteint le seuil de mise en conduction du transistor T1, qui devient donc passant. Un courant circule alors dans la branche comportant la résistance R1 et le transistor T1, et la tension aux bornes de la résistance R1 augmente jusqu'à atteindre le seuil de mise en conduction du transistor T2, qui devient passant. La tension aux bornes de la résistance R4 augmente alors jusqu'à atteindre le seuil de mise en conduction du transistor T3, qui devient passant. La charge LD est donc alimentée, et la tension de sortie Vs du circuit 300 devient sensiblement égale à la tension d'entrée Ve (à la chute de tension du transistor T3 près).

L'élément résistif Rf tend alors à abaisser le potentiel du noeud D en le tirant vers celui du noeud E (alors sensiblement égal à celui du noeud B), et contribue donc au maintien à l'état passant du transistor T1.

Lorsque la tension Ve redescend sous un seuil $V_{SB}$ inférieur au seuil $V_{SH}$, la tension aux bornes de la résistance R3 n'est plus suffisante pour maintenir le transistor T1 à l'état passant. Le blocage du transistor T1 entraine alors celui du transistor T2, puis celui du transistor T3.

Ainsi, le circuit 300 de la figure 3 présente, comme dans les exemples précédents, un fonctionnement de type hystérésis, les seuils de commutation $V_{SH}$ et $V_{SB}$ étant les mêmes que dans l'exemple de la figure 2, à la différence près que le terme Rf dans la formule de calcul susmentionnée doit être remplacé par Rf+R4.

A titre de variante, le transistor T3 peut être remplacé par un transistor bipolaire de type PNP, dont l'émetteur est relié au noeud A, dont le collecteur est relié au noeud F, et dont la base est reliée au noeud E. L'utilisation d'un transistor MOS présente toutefois l'avantage de réduire la consommation électrique du circuit 300.

Un avantage du mode de réalisation de la figure 3 est que la charge LD a un noeud d'alimentation relié à la masse (noeud B), ce qui permet d'obtenir une commande robuste, et d'éviter des commutations indésirables liées à des signaux transitoires parasites.

On notera qu'une variante de réalisation complémentaire du circuit 300 de la figure 3 peut être réalisée en inversant les types de conductivité des transistors T1, T2 et T3. Cette variante de réalisation n'a pas été représentée et ne sera pas détaillée, mais découle directement des exemples précédents. A titre d'exemple, cette variante peut être obtenue en ajoutant au circuit 100 de la figure 1 une résistance R4 entre les noeuds E et B, et un transistor MOS à canal N ou un transistor bipolaire de type NPN T3 entre le noeud B et un noeud F, le noeud de commande de ce transistor T3 étant relié au noeud E. La charge LD est alors connectée entre les noeuds A et F, qui constituent les noeuds de fourniture de la tension de sortie Vs du circuit.

La figure 4 est un schéma électrique illustrant une autre variante de réalisation d'un circuit de comparaison d'une tension d'entrée Ve à un seuil. Le circuit de comparaison 400 de la figure 4 comprend sensiblement les mêmes éléments que le circuit 200 de la figure 2, et diffère du circuit 200 essentiellement en ce que, dans le circuit 400, la résistance Rf est remplacée par une association en série d'une résistance Rf et d'un condensateur Cf reliant les noeuds D et E. Plus particulièrement, dans l'exemple représenté, la résistance Rf a une première extrémité reliée au noeud D et une deuxième extrémité reliée à un noeud G, et le condensateur Cf a une première électrode reliée au noeud G et une deuxième électrode reliée au noeud E. La résistance Rf et le condensateur Cf peuvent toutefois être intervertis. En d'autres termes, dans l'exemple de la figure 4, la résistance Rf est remplacée par une cellule RC.

Le fonctionnement du circuit 400 est similaire à celui du circuit 200 de la figure 4, à la différence près que le circuit 400 ne présente pas un fonctionnement à hystérésis, mais présente un seul seuil de commutation, correspondant au seuil $V_{SH} = V_{SB}$ du circuit de la figure 2 dans le cas où la valeur Rf des formules de calcul mentionnées en relation avec la figure 2 est infinie (soit $V_{SH} = V_{SB} = Von*R2*(1/R3 + 1/R2)$). Après une commutation de l'état bloqué vers l'état passant, le circuit 400 reste passant pendant une durée $\tau$ dépendant notamment des valeurs de la résistance Rf et du condensateur Cf.

Ainsi, lorsque la tension d'entrée Ve est basse, le circuit 400 est bloqué, et la charge LD n'est pas alimentée. La tension de sortie Vs du circuit 400 est alors sensiblement nulle.

Lorsque la tension Ve augmente jusqu'à franchir le seuil $V_{SH}$, la tension de sortie Vs du circuit 400 devient sensiblement égale à la tension d'entrée Ve (à la chute de tension du transistor T2 près), et la charge LD est alimentée.

A la commutation à l'état passant du circuit 400, le front descendant de la tension entre les noeuds E et B est transmis au noeud G par le condensateur Cf, ce qui tend à abaisser le potentiel du noeud D et contribue ainsi au maintien à l'état passant du transistor T1 tant que le condensateur Cf n'est pas déchargé. Le circuit 400 reste passant et alimente la charge LD pendant une durée $\tau$ ajustable notamment par la valeur de la résistance Rf et par la valeur du condensateur Cf.

A l'issue de cette durée d'alimentation, si la tension Ve est redescendue sous le seuil $V_{SH}$, le circuit 400 se bloque, et cesse d'alimenter la charge LD. La tension de sortie Vs est alors sensiblement nulle.

Bien que le circuit 400 de la figure 4 ne présente pas un fonctionnement à hystérésis, la présence de la cellule RC entre les noeuds D et E permet, en garantissant une durée minimale d'alimentation de la charge LD, d'éviter une oscillation indésirable entre le mode alimenté et le mode non alimenté de la charge LD, notamment dans le cas où la commutation de l'état bloqué vers l'état passant s'accompagne d'un fort appel de courant dans la charge LD.

A titre d'exemple non limitatif, dans l'exemple de la figure 4, la valeur de la résistance Rf est comprise entre 100 kΩ et 10 MΩ, par exemple de l'ordre de 1 MΩ, et la capacité du condensateur Cf est comprise entre 1 nF et 100 nF, par exemple de l'ordre de 10 nF.

A titre de variante, la cellule RC peut être remplacée par une capacité seule, ou par une cellule RC d'un autre type, par exemple une association parallèle d'une résistance Rf et d'un condensateur Cf. De plus, un élément résistif supplémentaire (non représenté) et/ou un élément capacitif supplémentaire (non représenté) peuvent être reliés en parallèle de la cellule RC, entre les noeuds D et E.

On notera que la variante de réalisation de la figure 4 est compatible avec tous les exemples de circuits de comparaison décrits précédemment, c'est-à-dire que dans chacun des circuits décrits en relation avec les figures 1, 2 et 3, la résistance Rf peut être remplacée par une cellule RC, ou par une association parallèle d'une cellule RC et d'un élément résistif et/ou d'un élément capacitif.

Par ailleurs, dans chacun des exemples des figures 1 à 4, le circuit de comparaison peut en outre comprendre une résistance de décharge, non représentée, entre les noeuds de fourniture de la tension de sortie Vs, en parallèle de la charge LD. La prévision d'une telle résistance de décharge est notamment avantageuse lorsque la charge LD est une diode électroluminescente ou une association de plusieurs diodes électroluminescentes, ou comprend des éléments capacitifs ou inductifs, la résistance de décharge permettant alors de ramener plus rapidement à zéro la tension Vs lors de la commutation du circuit de l'état passant vers l'état non passant. A titre d'exemple non limitatif, la résistance de décharge peut avoir une valeur comprise entre 10 kΩ et 5 MΩ, par exemple de l'ordre de 100 kΩ.

De plus, dans chacun des exemples des figures 1 à 4, pour réduire l'influence de la température sur le ou les seuils de commutation du circuit de comparaison, l'une et/ou l'autre des résistances R2 et R3 du pont diviseur de tension (de préférence la résistance R3) peut être remplacée par une thermistance, ou par une association série et/ou parallèle comportant une ou plusieurs résistances et une ou plusieurs thermistances, choisie pour compenser la dérive en température de la tension Von de mise en conduction du transistor T1 (de façon à maintenir le ou les seuils de commutation du circuit sensiblement indépendants de la température).

Un avantage des circuits de comparaison décrits en relation avec les figures 1 à 4 réside dans leur très faible consommation électrique, qui rend leur utilisation particulièrement avantageuse dans des systèmes à faibles ressources énergétiques, notamment dans des générateurs à récupération d'énergie ambiante.

La figure 5 est un schéma électrique illustrant un exemple d'un mode de réalisation d'un générateur à récupération d'énergie ambiante comportant un circuit de comparaison d'une tension à un seuil du type décrit en relation avec les figures 1 à 4.

Le générateur de la figure 5 comprend un élément 501 de conversion d'énergie ambiante en électricité, par exemple un élément de conversion piézoélectrique.

Le générateur de la figure 5 comprend en outre un premier circuit 510 de mise en forme de l'énergie électrique produite par l'élément 501. Dans l'exemple représenté, le circuit 510 comprend un circuit redresseur de tension 512 et un condensateur Cb1 de stockage de l'énergie électrique produite par l'élément 501. L'élément 501 est connecté entre des noeuds d'entrée H et I du circuit redresseur 512, qui constituent des noeuds d'entrée du circuit 510, et le condensateur Cb1 est connecté entre des noeuds de sortie J et K du circuit redresseur 512, qui constituent des noeuds de sortie du circuit 510. Plus particulièrement, dans l'exemple représenté, le circuit redresseur 512 est un pont de diodes comportant une première branche de deux diodes en série entre les noeuds K et J, et, en parallèle de la première branche, une deuxième branche de deux diodes en série entre les noeuds K et J, les quatre diodes du pont ayant toutes le même sens de conductivité, à savoir que chaque diode a son anode côté noeud K et sa cathode côté noeud J. Dans cet exemple, le point milieu de la première branche est relié au noeud H, et le point milieu de la deuxième branche est relié au noeud I.

Le générateur de la figure 5 comprend en outre un circuit de comparaison d'une tension à un seuil du type décrit en relation avec les figures 1 à 4, le circuit 400 de la figure 4 dans cet exemple. Les noeuds de sortie J et K du circuit de conversion 510 sont reliés respectivement aux noeuds d'entrée A et B du circuit de comparaison 400.

Le générateur de la figure 5 comprend en outre, en sortie du circuit de comparaison 400, un circuit 520 de chargement inductif d'un deuxième condensateur Cb2, de capacité supérieure à celle du condensateur Cb1. Le circuit 520 comprend des noeuds d'entrée L et M reliés respectivement aux noeuds de sortie A et E du circuit 400, et des noeuds de sortie N et O, le condensateur Cb2 étant connecté entre les noeuds N et O. Dans cet exemple, le noeud O est relié au noeud B du circuit de comparaison 400.

Le circuit 520 est un circuit abaisseur de tension (type convertisseur Buck), c'est-à-dire que la tension qu'il délivre aux bornes du condensateur Cb2 est inférieure à la tension d'entrée appliquée entre les noeuds L et O du circuit 520.

Le circuit 520 comprend une résistance R5 dont une première extrémité est reliée au noeud L et dont une deuxième extrémité est reliée au noeud M, et un transistor T4 dont un premier noeud de conduction est relié au noeud L, dont un deuxième noeud de conduction est relié à un noeud P, et dont un noeud de commande est relié au noeud M. Dans cet exemple, le transistor T4 est un transistor MOS à canal P dont les régions de source (s) et de drain (d) sont reliées respectivement aux noeuds L et P, et dont la grille (g) est reliée au noeud M. Le circuit 520 comprend de plus une inductance L1 dont une première extrémité est reliée au noeud P et dont une deuxième extrémité est reliée au noeud N, et une diode D1, ou diode de roue libre du circuit de puissance, dont l'anode est reliée au noeud O et dont la cathode est reliée au noeud P.

Une charge à alimenter (non représentée) peut être connectée aux noeuds de sortie N et O du circuit 520, qui constituent, dans cet exemple, des noeuds de sortie du générateur.

Le fonctionnement du générateur de la figure 5 est le suivant. L'élément 501 de conversion d'énergie ambiante en électricité et le circuit de redressement 512 forment une source d'énergie électrique délivrant un courant à la capacité Cb1, entrainant l'apparition d'une tension Ve aux bornes de la capacité Cb1, cette tension étant elle-même appliquée à l'entrée du circuit de comparaison 400.

Lorsque la tension d'entrée Ve délivrée aux bornes du condensateur Cb1 est basse, le circuit 400 est bloqué, et la tension Vs délivrée par le circuit 400 aux bornes de la résistance d'entrée R5 du circuit 520 est approximativement nulle.

Lorsque la tension d'entrée Ve dépasse le seuil de commutation $V_{SH}$ du circuit 400, la tension de sortie Vs du circuit 400 devient sensiblement égale à la tension d'entrée Ve (à la chute de tension du transistor T2 près), ce qui entraine la mise en conduction du transistor T4.

Le circuit 400 reste alors passant pendant une durée $\tau$ ajustable notamment par la valeur de la résistance Rf et par la valeur du condensateur Cf.

Pendant toute la durée de conduction du circuit 400, la tension Ve charge, à travers l'inductance L1, le condensateur Cb2.

Après la durée $\tau$, si la tension Ve est redescendue sous le seuil $V_{SH}$, le circuit 400 se bloque, et la tension Vs s'annule jusqu'à ce que la tension Ve remonte au-dessus du seuil $V_{SH}$. Pendant la période de blocage du circuit 400, la diode de roue libre D1 finit de transférer dans le condensateur Cb2 l'énergie résiduelle présente dans l'inductance L1.

Ainsi, le générateur de la figure 5 permet de charger le condensateur Cb2 à l'aide du circuit inductif 520, à partir d'un condensateur Cb1 de plus petite capacité. Ce montage permet d'éviter de mettre un condensateur de grande capacité directement en sortie de l'élément de conversion 501, ce qui dégraderait le rendement de l'élément de conversion 501.

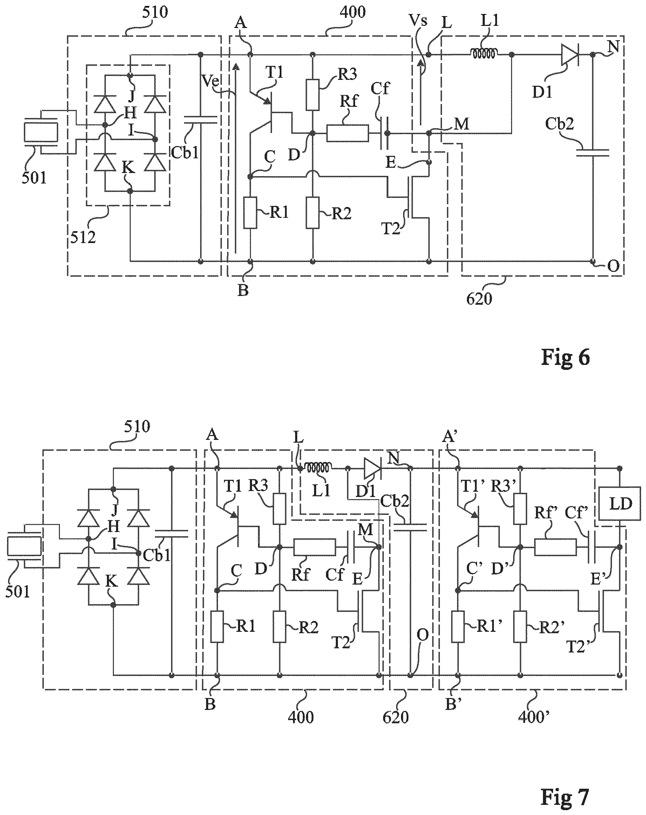

La figure 6 est un schéma électrique illustrant une variante de réalisation d'un générateur à récupération d'énergie ambiante comportant un circuit de comparaison d'une tension à un seuil du type décrit en relation avec les figures 1 à 4.

Le générateur de la figure 6 diffère du générateur de la figure 5 essentiellement en ce que le circuit de chargement abaisseur de tension 520 du générateur de la figure 5 a été remplacé par un circuit de chargement élévateur de tension 620 (type convertisseur Boost).

Le circuit 620 comprend, comme dans l'exemple de la figure 5, des noeuds d'entrée L et M reliés respectivement aux noeuds de sortie A et E du circuit de comparaison 400, et des noeuds de sortie N et O connectés aux électrodes d'un condensateur Cb2 de capacité supérieure à celle du condensateur Cb1. Dans cet exemple, le noeud O est relié au noeud B du circuit de comparaison 400. Le circuit 620 comprend une inductance L1 dont une première extrémité est reliée au noeud L et dont la deuxième extrémité est reliée au noeud M, et une diode D1 dont l'anode est reliée au noeud M et dont la cathode est reliée au noeud N.

Une charge à alimenter (non représentée) peut être connectée aux noeuds de sortie N et O du circuit 620, qui constituent, dans cet exemple, des noeuds de sortie du générateur.

Le fonctionnement du générateur de la figure 6 est identique ou similaire à celui de la figure 5, à la différence près que, dans l'exemple de la figure 6, la tension de sortie du générateur délivrée aux bornes du condensateur Cb2, est supérieure à la tension aux bornes du condensateur Cb1.

La figure 7 est un schéma électrique illustrant une autre variante de réalisation d'un générateur à récupération d'énergie ambiante comportant un circuit de comparaison d'une tension à un seuil du type décrit en relation avec les figures 1 à 4.

Le générateur de la figure 7 comprend les mêmes éléments que le générateur de la figure 6, agencés sensiblement de la même manière, et comprend en outre un deuxième circuit de comparaison de tension 400'. Dans cet exemple, le circuit 400' est identique au circuit 400, avec des valeurs de composants pouvant être différentes, et tous les éléments du circuit 400' ont été désignés sur la figure 7 par les mêmes références que celles de la figure 4, complétées par le signe "'".

Les noeuds d'entrée A' et B' du circuit 400' sont reliés respectivement aux noeuds de sortie N et O du circuit 620. Une charge LD à alimenter est connectée entre les noeuds de sortie A' et E' du circuit 400', qui constituent les noeuds de sortie du générateur de la figure 7.

Ainsi, dans l'exemple de la figure 7, chaque fois que la tension aux bornes du condensateur Cb2 dépasse le seuil de commutation du circuit de comparaison 400', la charge LD est alimentée pendant une durée τ', par une tension sensiblement égale à la tension aux bornes du condensateur Cb2 (à la chute de tension du transistor T2' près).

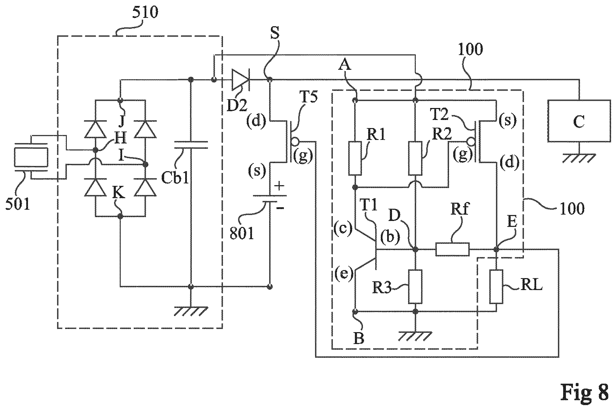

La figure 8 est un schéma électrique d'une autre variante de réalisation d'un générateur à récupération d'énergie ambiante comportant un circuit de comparaison d'une tension à un seuil du type décrit en relation avec les figures 1 à 4.

Comme dans les exemples des figures 5, 6 et 7, le générateur de la figure 8 comprend un élément 501 de conversion d'énergie ambiante en électricité, et un circuit 510 de mise en forme de l'énergie électrique produite par l'élément 501. Ces éléments sont par exemple identiques à ce qui a été décrit précédemment.

Le générateur de la figure 8 comprend en outre une batterie d'appoint 801 destinée à prendre le relais pour l'alimentation d'une charge C, par exemple un capteur ou une source lumineuse, lorsque le convertisseur d'énergie ambiante en électricité ne fournit pas assez d'électricité. Dans cet exemple, la batterie est connectée en série avec une diode D2 et un transistor MOS à canal P T5 entre les noeuds de sortie J et K du circuit 510 (en parallèle du condensateur Cb1). Plus particulièrement, dans l'exemple représenté, l'anode de la diode D2 est connectée au noeud J, la cathode de la diode D2 est connectée au drain du transistor T5, la source du transistor T5 est connectée à la borne positive (+) de la batterie 801, et la borne négative (-) de la batterie 801 est connectée au noeud K.

Le générateur de la figure 8 comprend en outre un circuit de comparaison d'une tension à un seuil du type décrit en relation avec les figures 1 à 4, le circuit 100 de la figure 1 dans cet exemple. Les noeuds de sortie J et K du circuit de conversion 510 sont connectés respectivement aux noeuds d'entrée A et B du circuit de comparaison 100. Le générateur de la figure 8 comprend de plus, en sortie du circuit de comparaison 100, une résistance RL. Dans l'exemple représenté, les extrémités de la résistance RL sont connectées respectivement aux noeuds E et B de sortie du circuit 100. Le noeud E est en outre relié (connecté dans l'exemple représenté) à la grille (g) du transistor T5.

La charge C à alimenter a ses bornes d'alimentation positive et négative connectées respectivement au point milieu S entre la diode D2 et le transistor T5, et au noeud K.

A l'état déchargé, la tension aux bornes du condensateur Cb1 est sensiblement nulle, et le transistor T5 est passant. La charge C est alors alimentée uniquement par la batterie 801. Lorsque de l'énergie ambiante est convertie en électricité par l'élément 501, le condensateur Cb1 se charge. Lorsque la tension aux bornes du condensateur Cb1 atteint le seuil de commutation haut du comparateur à hystérésis, le circuit 100 commute, ce qui entraîne l'ouverture du transistor T5. La charge C est alors alimentée par le condensateur Cb1 via la diode D2.

Si la tension aux bornes du condensateur Cb1 continue d'augmenter, le circuit de conversion 510 recharge la batterie 801 par l'intermédiaire de la diode intrinsèque drain-source du transistor 801, tout en continuant à alimenter la charge C. Si la tension aux bornes du condensateur Cb1 atteint le seuil de commutation bas du comparateur à hystérésis, le circuit 100 commute à nouveau, ce qui entraîne la mise à l'état passant du transistor T5. La charge C est alors alimentée uniquement par la batterie 801, jusqu'à ce que la tension aux bornes du condensateur Cb1 atteigne à nouveau le seuil de commutation haut du comparateur à hystérésis.

Des modes de réalisation particuliers ont été décrits. Diverses variantes et modifications apparaîtront à l'homme de l'art.

En particulier, les circuits de comparaison de tension du type décrit en relation avec les figures 1 à 4 peuvent être utilisés dans d'autres applications que des générateurs à récupération d'énergie ambiante. A titre d'exemple non limitatif, un circuit de comparaison d'une tension à un seuil du type décrit en relation avec les figures 1 à 4 peut être utilisé pour surveiller la charge et/ou la décharge d'une batterie, par exemple en vue de déclencher une alarme ou un interrupteur de déconnexion lorsqu'un niveau de charge et/ou de décharge critique est atteint.

De plus, pour une utilisation dans un générateur à récupération d'énergie ambiante, les modes de réalisation décrits ne se limitent pas aux exemples particuliers d'architectures de générateurs décrits en relation avec les figures 5 à 7.

A titre de variante, un générateur à récupération d'énergie ambiante peut comporter uniquement la partie amont du générateur de la figure 5, sans le circuit de chargement inductif 520, une charge à alimenter pouvant alors être connectée entre les noeuds de sortie du circuit de comparaison.

En outre, l'homme du métier saura adapter l'exemple de la figure 6 pour remplacer le circuit de chargement inductif 620 par un circuit de chargement de type Flyback, c'est-à-dire un circuit comportant un transformateur permettant de charger le condensateur Cb2 à partir de la tension Ve.

De plus, l'homme du métier saura adapter les exemples des figures 5 à 7, en remplaçant les circuits de comparaison 400, 400' par des circuits de comparaison du type décrit en relation avec les figures 1 à 3.

En outre, dans l'exemple de la figure 7, les deux circuits de comparaison de tension 400 et 400' peuvent ne pas être identiques, mais présenter des architectures différentes, choisies parmi les architectures décrites en relation avec les figures 1 à 4.

Par ailleurs, on peut prévoir un générateur du type décrit en relation avec la figure 7, comportant plusieurs étages de chargement inductif cascadés, séparés par des circuits de comparaison de tension du type décrit en relation avec les figures 1 à 4.

## Revendications

1. Circuit (100 ; 200 ; 300 ; 400) de comparaison d'une tension (Ve) à un seuil, comportant :

   des premier (A) et deuxième (B) noeuds d'application de ladite tension (Ve) ;
   une première branche comportant un premier transistor (T1) en série avec une première résistance (R1) entre les premier (A) et deuxième (B) noeuds ;
   une deuxième branche parallèle à la première branche, comportant des deuxième (R2) et troisième (R3) résistances en série formant un pont diviseur de tension entre les premier (A) et deuxième (B) noeuds, le point milieu (D) du pont diviseur étant connecté directement à un noeud de commande du premier transistor (T1) ; et
   une troisième branche comportant : un deuxième transistor (T2) dont les noeuds de conduction sont connectés directement respectivement au premier (A) ou deuxième (B) noeud et à un troisième noeud (E), et dont un noeud de commande est connecté directement au point milieu (C) de l'association en série du premier transistor (T1) et de la première résistance (R1) ; et une résistance (Rf) ou un condensateur (Cf) ou une association série ou parallèle d'une résistance (Rf) et d'un condensateur (Cf), dont les extrémités sont connectées directement respectivement au troisième noeud (E) et au noeud (D) de commande du premier transistor (T1).

2. Circuit (100 ; 200 ; 400) selon la revendication 1, dans lequel le troisième noeud (E), et le premier ou deuxième noeud (A ; B) d'application de ladite tension (Ve) non connecté à la troisième branche, constituent des noeuds de fourniture d'une tension de sortie (Vs) du circuit, destinés à être connectés Z directement à une charge (LD) à alimenter.

3. Circuit (300) selon la revendication 1, comportant en outre :

   entre le troisième noeud (E), et le premier ou deuxième noeud (A ; B) d'application de ladite tension (Ve) non connecté à la troisième branche, une quatrième résistance (R4) ; et
   entre le premier ou deuxième noeud (A ; B) d'application de ladite tension (Ve) non connecté à la troisième branche et un quatrième noeud (F), un troisième transistor (T3) dont un noeud de commande est relié au troisième noeud (E), dans lequel le premier ou deuxième noeud (B ; A) d'application de ladite tension (Ve) connecté à la troisième branche, et le quatrième noeud (F), constituent des noeuds de fourniture d'une tension de sortie (Vs) du circuit, destinés à être connectés directement à une charge (LD) à alimenter.

4. Circuit (100) selon l'une quelconque des revendications 1 à 3, dans lequel :

   le premier transistor (T1) est un transistor bipolaire NPN ou un transistor MOS à canal N ;
   le deuxième transistor (T2) est un transistor MOS à canal P ou un transistor bipolaire PNP ;
   dans la première branche, la première résistance (R1) est côté premier noeud (A) et le premier transistor (T1) est côté deuxième noeud (B) ; et
   la troisième branche est entre le noeud (D) de commande du premier transistor (T1) et le premier noeud (A).

5. Circuit (200 ; 300 ; 400) selon l'une quelconque des revendications 1 à 3, dans lequel :

   le premier transistor (T1) est un transistor bipolaire PNP ou un transistor MOS à canal P ;
   le deuxième transistor (T2) est un transistor MOS à canal N ou un transistor bipolaire NPN ;
   dans la première branche, la première résistance (R1) est côté deuxième noeud (B) et le premier transistor (T1) est côté premier noeud (A) ; et
   la troisième branche est entre le noeud (D) de commande du premier transistor (T1) et le deuxième noeud (B).

6. Circuit (100 ; 200 ; 300) selon l'une quelconque des revendications 1 à 5, dans lequel la résistance (Rf) ou le condensateur (Cf) ou l'association série ou parallèle d'une résistance (Rf) et d'un condensateur (Cf) est une résistance (Rf).

7. Circuit (400) selon l'une quelconque des revendications 1 à 5, dans lequel la résistance (Rf) ou le condensateur (Cf) ou l'association série ou parallèle d'une résistance (Rf) et d'un condensateur (Cf) est une association série ou parallèle d'une résistance (Rf) et d'un condensateur (Cf) .

8. Circuit (100 ; 200 ; 300 ; 400) selon l'une quelconque des revendications 1 à 7, dans lequel au moins l'une des deuxième (R2) et troisième (R3) résistances est une thermistance ou une association d'une ou plusieurs résistances et d'une ou plusieurs thermistances.

9. Générateur à récupération d'énergie ambiante, comportant :

   un élément (501) de conversion d'énergie ambiante en énergie électrique ;
   un premier condensateur (Cb1) adapté à stocker des charges générées par ledit élément de conversion (501) ; et

un premier circuit de comparaison (400) selon l'une quelconque des revendications 1 à 8, le premier condensateur (Cb1) étant connecté directement entre les premier (A) et deuxième (B) noeuds du premier circuit de comparaison.

10. Générateur selon la revendication 9, comportant en outre un circuit de chargement inductif (520 ; 620) d'un deuxième condensateur (Cb2) à partir de la tension d'entrée (Ve) et du premier circuit de comparaison (400).

11. Générateur selon la revendication 10, dans lequel le circuit de chargement inductif (520) est un circuit abaisseur de tension.

12. Générateur selon la revendication 10, dans lequel le circuit de chargement inductif (620) est un circuit élévateur de tension.

13. Générateur selon l'une quelconque des revendications 10 à 12, comportant en outre un deuxième circuit de comparaison (400') selon l'une quelconque des revendications 1 à 8, le deuxième condensateur (Cb2) étant connecté directement entre les premier (A') et deuxième (B') noeuds du deuxième circuit de comparaison.

14. Générateur selon la revendication 9, comprenant en outre une diode (D2), un transistor (T5) et une batterie électrique d'appoint (801) connectés directement en série entre les bornes du premier condensateur (Cb1).

**Patentansprüche**

1. Eine Schaltung (100; 200; 300; 400) zum Vergleichen einer Spannung (Ve) mit einem Schwellenwert, die Folgendes aufweist:

erste (A) und zweite (B) Knoten zum Anlegen der Spannung (Ve);
einen ersten Zweig, der einen ersten Transistor (T1) aufweist, der in Reihe mit einem ersten Widerstand (R1) zwischen den ersten (A) und zweiten (B) Knoten gekoppelt ist;
einen zweiten Zweig, der parallel zu dem ersten Zweig ist und zweite (R2) und dritte (R3) Widerstände aufweist, die in Serie gekoppelt eine Spannungsteilerbrücke zwischen dem ersten (A) und zweiten (B) Knoten bilden, wobei der Mittelpunkt (D) der Spannungsteilerbrücke direkt mit einem Steuerknoten des ersten Transistors (T1) verbunden ist; und
einen dritten Zweig, der Folgendes aufweist: einen zweiten Transistor (T2), der seinen Leitungsknoten jeweils direkt verbunden mit dem ersten (A) oder zweiten (B) Knoten und mit einem dritten Knoten (E) hat, und der einen Steuerknoten direkt verbunden mit dem Mittelpunkt (C) des ersten Transistors (T1) und des ersten Widerstandes (R1) hat; und einen Widerstand (Rf) oder einen Kondensator (Cf) oder eine Serien- oder Parallelassoziation eines Widerstandes (Rf) und eines Kondensators (Cf), die ihre Enden jeweils direkt mit dem dritten Knoten (E) und mit dem Steuerknoten (D) des ersten Transistors (T1) verbunden haben.

2. Schaltung (100; 200; 400) nach Anspruch 1, wobei der dritte Knoten (E) und der erste oder zweite Knoten (A; B) zum Anlegen der Spannung (Ve), der nicht mit dem dritten Zweig verbunden ist, Knoten zum Liefern einer Ausgangsspannung (Vs) der Schaltung bilden mit dem Ziel der direkten Verbindung mit einer mit Leistung zu versorgenden Last (LD).

3. Schaltung (300) nach Anspruch 1, die ferner Folgendes aufweist:

zwischen dem dritten Knoten (E) und dem ersten oder zweiten Knoten (A; B) zum Anlegen der Spannung (Ve), der nicht mit dem dritten Zweig gekoppelt ist, ein vierter Widerstand (R4); und zwischen dem ersten oder zweiten Knoten (A; B) zum Anlegen der Spannung (Ve), der nicht mit dem dritten Zweig gekoppelt ist, und einem vierten Knoten (F), einen dritten Transistor (T3), der einen Steuerknoten besitzt, der mit dem dritten Knoten (E) gekoppelt ist,
wobei der erste oder zweite Knoten (B; A) zum Anlegen der Spannung (Ve), der mit dem dritten Zweig und dem vierten Knoten (F) gekoppelt ist, Knoten zum Liefern einer Ausgangsspannung (Vs) der Schaltung bildet, mit dem Ziel des direkten Verbindens mit einer mit Energie zu versorgenden Last (LD).

4. Schaltung (100) nach einem der Ansprüche 1 bis 3, wobei:

der erste Transistor (T1) ein NPN-Bipolartransistor oder ein N-Kanal-MOS-Transistor ist;
der zweite Transistor (T2) ein P-Kanal-MOS-Transistor oder ein PNP-Bipolartransistor ist;
in dem ersten Zweig, der erste Widerstand (R1) auf der Seite des ersten Knotens (A) und der erste Transistor (T1) auf der Seite des zweiten Knotens (B) ist; und
der dritte Zweig zwischen dem Steuerknoten (D) des ersten Transistors (T1) und dem ersten Knoten (A) liegt.

**5.** Schaltung (200; 300; 400) nach einem der Ansprüche 1 bis 3, wobei:

der erste Transistor (T1) ein PNP-Bipolartransistor oder ein P-Kanal-MOS-Transistor ist; der zweite Transistor (T2) ein N-Kanal-MOS-Transistor oder ein NPN-Bipolartransistor ist; in dem ersten Zweig, der erste Widerstand (R1) auf der Seite des zweiten Knotens (B) und der erste Transistor (T1) auf der Seite des ersten Knotens (A) ist; und der dritte Zweig zwischen dem Steuerknoten (D) des ersten Transistors (T1) und dem zweiten Knoten (B) liegt.

**6.** Schaltung (100; 200; 300) nach einem der Ansprüche 1 bis 5, wobei der Widerstand (Rf) oder der Kondensator (Cf) oder die Serien-oder Parallelassoziation aus einem Widerstand (Rf) und einem Kondensator (Cf) ein Widerstand (Rf) ist.

**7.** Schaltung (400) nach einem der Ansprüche 1 bis 5, wobei der Widerstand (Rf) oder der Kondensator (Cf) oder die Serien-oder Parallelassoziation aus einem Widerstand (Rf) und einem Kondensators (Cf) eine Serien-oder Parallelassoziation aus einem Widerstand (Rf) und einem Kondensator (Cf) ist.

**8.** Schaltung (100; 200; 300; 400) nach einem der Ansprüche 1 bis 7, wobei mindestens einer der zweiten (R2) und dritten (R3) Widerstände ein Thermistor oder eine Assoziation von einem oder einer Vielzahl von Widerständen und von einem oder einer Vielzahl von Thermistoren ist.

**9.** Ein Umgebungsenergie-Gewinnungs-Generator, der Folgendes aufweist:

ein Element (501) zum Umwandeln von Umgebungsenergie in elektrische Energie; einen ersten Kondensator (Cb1), der geeignet ist, Ladungen zu speichern, die von dem Konversionselement (501) erzeugt werden; und eine erste Vergleichsschaltung (400) nach einem der Ansprüche 1 bis 8, wobei der erste Kondensator (Cb1) direkt zwischen dem ersten (A) und zweiten (B) Knoten der ersten Vergleichsschaltung verbunden ist.

**10.** Generator nach Anspruch 9, der ferner eine Schaltung (520; 620) zum induktiven Laden eines zweiten Kondensators (Cb2) aus der Eingangsspannung (Ve) und der ersten Vergleichsspannung (400) aufweist.

**11.** Generator nach Anspruch 10, wobei die induktive Ladeschaltung (520) eine Spannungsabwärtsschaltung ist.

**12.** Generator nach Anspruch 10, wobei die induktive Ladeschaltung (620) eine Spannungsaufwärtsschaltung ist.

**13.** Generator nach einem der Ansprüche 10 bis 12, der ferner eine zweite Vergleichsschaltung (400') nach einem der Ansprüche 1 bis 8 aufweist, wobei der zweite Kondensator (Cb2) direkt zwischen dem ersten (A') und zweiten (B') Knoten der zweiten Vergleichsschaltung verbunden ist.

**14.** Generator nach Anspruch 9, der ferner eine Diode (D2), einen Transistor (T5) und eine elektrische Zusatzbatterie (801) aufweist, die direkt in Serie zwischen den Anschlüssen des ersten Kondensators (Cb1) verbunden sind.

## Claims

**1.** A circuit (100; 200; 300; 400) for comparing a voltage (Ve) with a threshold, comprising:

first (A) and second (B) nodes of application of said voltage (Ve); a first branch comprising a first transistor (T1) coupled in series with a first resistor (R1) between the first (A) and second (B) nodes; a second branch parallel to the first branch, comprising second (R2) and third (R3) resistors coupled in series forming a voltage dividing bridge between the first (A) and second (B) nodes, the midpoint (D) of the dividing bridge being directly connected to a control node of the first transistor (T1); and a third branch comprising: a second transistor (T2) having its conduction nodes respectively directly connected to the first (A) or second (B) node and to a third node (E), and having a control node directly connected to the junction point (C) of the first transistor (T1) and of the first resistor (R1); and a resistor (Rf) or a capacitor (Cf) or a series or parallel association of a resistor (Rf) and of a capacitor (Cf), having its ends respectively directly connected to the third node (E) and to the control node (D) of the first transistor (T1).

**2.** The circuit (100; 200; 400) of claim 1, wherein the third node (E) and the first or second node (A; B) of application of said voltage (Ve) not coupled to the third branch form nodes for providing an output voltage (Vs) of the circuit, intended to be directly connected to a load (LD) to be powered.

**3.** The circuit (300) of claim 1, further comprising:

between the third node (E) and the first or second node (A; B) of application of said voltage (Ve) not coupled to the third branch, a fourth resistor (R4); and

between the first or second node (A; B) of application of said voltage (Ve) not coupled to the third branch and a fourth node (F), a third transistor (T3) having a control node coupled to the third node (E),

wherein the first or second node (B; A) of application of said voltage (Ve) coupled to the third branch and the fourth node (F) form nodes for providing an output voltage (Vs) of the circuit, intended to be directly connected to a load (LD) to be powered.

4. The circuit (100) of any of claims 1 to 3, wherein:

the first transistor (T1) is an NPN bipolar transistor or an N-channel MOS transistor;
the second transistor (T2) is a P-channel MOS transistor or a PNP bipolar transistor;
in the first branch, the first resistor (R1) is on the side of the first node (A) and the first transistor (T1) is on the side of the second node (B); and
the third branch is located between the control node (D) of the first transistor (T1) and the first node (A).

5. The circuit (200; 300; 400) of any of claims 1 to 3, wherein:

the first transistor (T1) is a PNP bipolar transistor or a P-channel MOS transistor;
the second transistor (T2) is an N-channel MOS transistor or an NPN bipolar transistor;
in the first branch, the first resistor (R1) is on the side of the second node (B) and the first transistor (T1) is on the side of the first node (A); and
the third branch is located between the control node (D) of the first transistor (T1) and the second node (B).

6. The circuit (100; 200; 300) of any of claims 1 to 5, wherein the resistor (Rf) or the capacitor (Cf) or the series or parallel association of a resistor (Rf) and of a capacitor (Cf) is a resistor (Rf).

7. The circuit (400) of any of claims 1 to 5, wherein the resistor (Rf) or the capacitor (Cf) or the series or parallel association of a resistor (Rf) and of a capacitor (Cf) is a series or parallel association of a resistor (Rf) and of a capacitor (Cf) .

8. The circuit (100; 200; 300; 400) of any of claims 1 to 7, wherein at least one of the second (R2) and third (R3) resistors is a thermistor or an association of one or a plurality of resistors and of one or a plurality of thermistors.

9. An ambient energy harvesting generator, comprising:

an element (501) for converting ambient energy into electrical energy;
a first capacitor (Cb1) capable of storing charges generated by said conversion element (501); and
a first comparison circuit (400) of any of claims 1 to 8, the first capacitor (Cb1) being directly connected between the first (A) and second (B) nodes of the first comparison circuit.

10. The generator of claim 9, further comprising a circuit (520; 620) for inductively charging a second capacitor (Cb2) from the input voltage (Ve) and the first comparison circuit (400) .

11. The generator of claim 10, wherein the inductive charge circuit (520) is a voltage step-down circuit.

12. The generator of claim 10, wherein the inductive charge circuit (620) is a voltage step-up circuit.

13. The generator of any of claims 10 to 12, further comprising a second comparison circuit (400') of any of claims 1 to 8, the second capacitor (Cb2) being directly connected between the first (A') and second (B') nodes of the second comparison circuit.

14. The generator of claim 9, further comprising a diode (D2), a transistor (T5), and an electric booster battery (801) directly connected in series between the terminals of the first capacitor (Cb1).

Fig 1

Fig 2

14

Fig 3

Fig 4

Fig 5

**Fig 6**

**Fig 7**

Fig 8

**EP 3 035 530 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

* US 710598 A